# EUROPÄISCHE PATENTSCHRIFT

(11) **EP 2 930 529 B1**
(45) Veröffentlichungstag und Bekanntmachung des Hinweises auf die Patenterteilung: **26.10.2016**
(21) Anmeldenummer: 15157496.9
(22) Anmeldetag: 04.03.2015
(51) Int. Cl.: G01S 7/51, G01S 17/02, G01S 17/48, G01C 3/08, G01V 8/12, H03K 17/94, G01S 17/08

(54) **LICHTTASTER**
LIGHT SENSOR
détecteur photoélectrique

(30) Priorität: 08.04.2014 DE 102014104968
(43) Veröffentlichungstag der Anmeldung: 14.10.2015
(73) Patentinhaber: SICK AG, 79183 Waldkirch (DE)
(72) Erfinder: Leuker, Günter, 79183 Waldkirch (DE); Bornstein, Patrick, 79117 Freiburg (DE)
(74) Vertreter: Ludewigt, Christoph

(56) Entgegenhaltungen:
- EP-A2- 1 116 963
- DE-U1-202012 102 331

## Beschreibung

Die Erfindung betrifft einen Lichttaster mit Hintergrundausblendung nach dem Oberbegriff des Anspruchs 1.

Beispiele solcher Lichttaster sind aus der EP 1 116 963 A2 und DE 20 2012 102 331 U1 bekannt. Bei derartigen Lichttastern erfolgt die Einstellung des maximalen Schaltabstandes (Tastweite) entweder mit einem Potentiometer, einer Teach-Taste, extern durch eine Teach-Leitung oder mittels Displayanzeige. Die eingestellte Tastweite kann an einer Anzeige angezeigt werden, beispielsweise durch Abstandsangaben in mm oder durch Anzeigen, ob ein Schwellwert unter- oder überschritten ist. Wenn ein Objekt außerhalb der jeweiligen Tastweite liegt, dann wird dies nicht zusätzlich signalisiert.

Bei der Tastweiteneinstellung erhält der Anwender keine unmittelbare Rückmeldung am Sensor, ob die erforderliche Mindestdistanz (kritischer Abstandsbereich) zwischen Tastweite und Hintergrund eingehalten wird. Diese Mindestdistanz ist notwendig, weil einerseits Objekte innerhalb der Tastweite sicher erkannt werden sol-len und andererseits Objekte, die sich im Hintergrund befinden, zuverlässig ausgeblendet werden sollen. Der erforderliche Mindestabstand zwischen der eingestellten Tastweite und dem Hintergrund kann nur aus der Dokumentation (Datenblatt, Betriebsanleitung) zum Lichttaster entnommen werden und muss vor Ort nachgemessen werden.

Davon ausgehend ist es Aufgabe der Erfindung, einen verbesserten Lichttaster bereitzustellen, mit dem die vorgenannten Nachteile vermieden werden können und insbesondere eine verbesserte Tastweiteneinstellung, Objektdetektionsanzeige und eine verbesserte Berücksichtigung des kritischen Abstandsbereichs möglich ist.

Diese Aufgabe wird gelöst mit einem Lichttaster mit den Merkmalen des Anspruchs 1.

Der erfindungsgemäße Lichttaster mit Hintergrundausblendung umfasst einen Lichtsender, einen Lichtempfänger, eine Auswerteeinheit zur Bestimmung des Abstandes zwischen dem Lichttaster und einem Objekt im Erfassungsbereich des Lichttasters, ein Einstellelement zum Einstellen einer Tastweite, innerhalb derer ein Objekt detektiert werden soll, wobei zwischen eingestellter Tastweite und Hintergrund ein kritischer Abstandsbereich in Abhängigkeit von der eingestellten Tastweite definiert ist, einen Signalausgang zum Ausgeben eines Signals, wenn ein Objekt innerhalb der eingestellten Tastweite detektiert wird und eine Anzeigeeinheit zur Anzeige, ob ein Objekt sich innerhalb der Tastweite befindet, wobei die Anzeigeeinheit wenigstens zwei Anzeigebereiche aufweist, wobei der erste Anzeigebereich derart ausgebildet ist, dass die eingestellte Tastweite im Verhältnis zu einer maximalen Tastweite des Lichttasters anzeigbar ist und der zweite Anzeigebereich anzeigt, wenn ein Objekt sich im kritischen Abstandsbereich befindet wobei die Entfernung eines erfassten Objekts innerhalb der eingestellten Tastweite in dem ersten Anzeigebereich qualitativ anzeigbar ist.

Dadurch erhält der Anwender bei der Inbetriebnahme eine unmittelbare Rückmeldung am Sensor, ob die Tastweite korrekt eingestellt wurde, oder ob vielleicht die maximale Tastweite überschritten wurde. Auch erhält der Anwender eine Rückmeldung während des Betriebes, ob sich Objekte im kritischen Abstandsbereich befinden, die eine sichere Detektion stören könnten. Wenn nämlich ein Objekt zwischen der eingestellten Tastweite und dem Hintergrund erfasst wird, dann wird dies in dem zweiten Anzeigebereich signalisiert. Das zu detektierende Objekt liegt dann außerhalb der Tastweite und es befindet sich im kritischen Abstandsbereich und könnte die sichere Detektion stören. Dadurch kann während des Betriebs an der Anzeigeeinheit verbessert festgestellt werden, in welchem Abstandsbereich ein Objekt erfasst wird.

Mit dem erfindungsgemäßen Lichttaster kann bei der Inbetriebnahme die Einhaltung der spezifizierten maximalen Tastweite überprüft werden. Bei Überschreiten wird dies unmittelbar während der Einstellung durch die Anzeigeeinheit signalisiert.

Im Betrieb erfolgt mit der Erfindung vorteilhafterweise eine kontinuierliche Anzeige, ob die zu erfassenden Objekte sich innerhalb des eingestellten Tastbereiches befinden oder in einem der anderen Bereiche. Insbesondere kann erkannt werden, ob sich unerwünschte Objekte, die nicht detektiert werden sollen, in dem kritischen Abstandsbereich befinden. Es erfolgt eine unmittelbare Rückmeldung der vorgenannten Situationen an den Anwender direkt am Lichttaster und ohne Zuhilfenahme der Dokumentation oder eines externen Auswertegerätes.

Somit ermöglicht die Erfindung für den Anwender eine einfache und unmittelbare Rückmeldung bzw. Information am Lichttaster über die Qualität der eingestellten Tastweite und den Detektionsbedingungen. Der Aufwand für externe Auswertegeräte oder die Vermessung unter Zuhilfenahme der Dokumentation des Lichttasters entfällt.

In Weiterbildung der Erfindung ist ein dritter Anzeigebereich vorgesehen ist, in dem anzeigbar ist, ob sich ein erfasstes Objekt im Hintergrund befindet. Damit können die Abstandsbereiche bereits an der Anzeigeeinheit klarer erkannt und visualisiert werden und eine Zuordnung eines Objekts im Erfassungsbereich des Lichttasters kann klar einem Abstandsbereich zugeordnet werden.

Nach der Erfindung ist die Entfernung eines erfassten Objekts innerhalb der eingestellten Tastweite in dem ersten Anzeigebereich qualitativ anzeigbar, so dass bereits mit Blick auf die Anzeige der Anwender eine Vorstellung von der ungefähren Position des Objektes innerhalb der Tastweite hat.

In vorteilhafter Weise besteht der erste Anzeigebereich aus mehreren LED's, wobei ein aktivierter Teil der LEDs die eingestellte Tastweite angibt. Damit ist der eingestellte Arbeitsbereich des Lichttasters im Verhältnis zum maximalen Arbeitsbereich (maximale Tastweite) in einfacher Weise erkennbar.

Mit dieser Ausbildung kann die Entfernung des Objekts innerhalb der eingestellten Tastweite durch Erlöschen einer der aktivierten LEDs, die der Entfernung des Objekts zugeordnet ist, in einfacher Weise angezeigt werden. Dies gilt sowohl für die erstmalige Einstellung der Tastweite (Inbetriebnahme) als auch während des Betriebs.

Mit Vorteil ist ein Einstellmodus zum Einstellen der Tastweite aktivierbar, beispielsweise mittels einer Starttaste oder einem Startbefehl. Ein Ende des Einstellmodus wird durch die Auswerteeinheit automatisch erkannt, wenn das Einstellelement über eine vorbestimmte Zeit nicht betätigt wurde. Das ist sehr bedienerfreundlich und erleichtert die Bedienbarkeit.

In optisch ansprechender Weise ist die Anzeigeeinheit ringförmig ausgebildet und die Anzeigebereiche bilden Abschnitte des Ringes. Eine solche Anzeige ist zugleich platzsparend, so dass sie auch bei kleinen Baugrößen eingesetzt werden kann.

In vorteilhafter und platzsparender Weise ist das Einstellelement als Drehpotentiometer ausgebildet, das sich im Inneren des Ringes befindet. Anstelle des Potentiometers kann auch eine Einzel-Teach oder Doppel-Teach-Taste vorgesehen sein.

Der Lichttaster kann als Triangulationslichttaster ausgebildet sein. Triangulations-taster sind bekannt, haben sich bewährt und sind recht kostengünstig herstellbar. Alternativ können auch andere Technologien zur Entfernungsmessung eingesetzt werden. So könnte der Lichttaster auch als TOF-Taster (Time-Of-Flight) ausgebildet sein, wobei der Lichtsender dann moduliertes Licht aussendet und die Auswerteeinheit die Entfernung über eine Bestimmung der Lichtlaufzeit bestimmt.

Im Folgenden wird die Erfindung anhand von Ausführungsbeispielen unter Bezugnahme auf die Zeichnung im Einzelnen erläutert. In der Zeichnung zeigen:
- Fig. 1a: eine schematische Darstellung eines erfindungsgemäßen Lichttasters in einer Anwendungssituation mit einem Objekt in der Tastweite;
- Fig. 1b: eine Anzeigeeinheit in der Anwendungssituation nach Fig. 1a;
- Fig. 2a bis 3b: Darstellungen wie Fig. 1a bzw. 1 b bei anderen Objektabständen;
- Fig. 4 und 5: Ausführungsformen der Anzeigeeinheit.

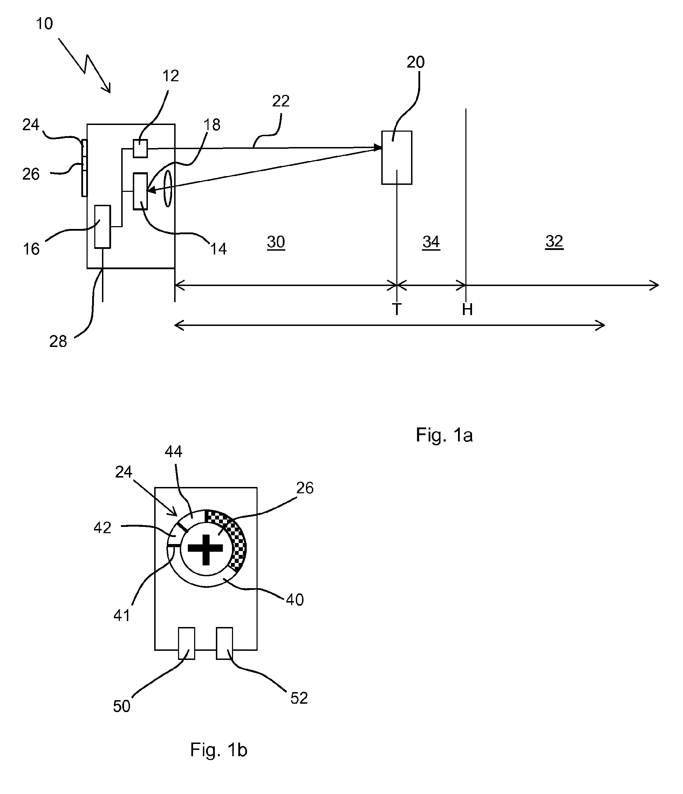

Ein in Fig. 1 dargestellter erfindungsgemäßer Lichttaster 10 umfasst einen Lichtsender 12 und einen Lichtempfänger 14, die mit einer Auswerteeinheit 16 verbunden sind. Der Lichttaster 10 in diesem Ausführungsbeispiel ist als Triangulationslichttaster ausgebildet, wobei in der Auswerteeinheit die Position des Auftreffpunkts 18 eines an einem Objekt 20 im Erfassungsbereich reflektierten Lichtstrahls 22 des Lichtsenders 12 auf dem Lichtempfänger 14 ermittelt wird und über die Position die Entfernung d zwischen Lichttaster 10 und Objekt 20 bestimmt wird.

Weiter weist der Lichttaster 10 eine Anzeigeeinheit 24 und wenigstens ein Einstellelement 26 auf. Mit dem Einstellelement 26 ist eine Tastweite T einstellbar. Die Tastweite T ist derjenige Abstand, bis zu dem das Objekt 20 detektiert werden soll und definiert somit einen Tastbereich 30. Wenn also das Objekt 20 sich in dem Tastbereich 30 mit einem Abstand d kleiner gleich T befindet, gibt der Lichttaster 10 ein Schaltsignal an seinem Ausgang 28 aus.

Wenn ein Objekt sich im Hintergrund 32 befindet, soll dieses Objekt ignoriert werden und kein Schaltsignal ausgegeben werden. Der Hintergrund 32 ist derjenige Bereich, der einen Abstand d größer H hat. Der Hintergrund 32, in dem Objekte sicher ausgeblendet werden, hat also von dem Tastbereich 30, in dem ein Objekt 20 sicher erkannt werden soll, einen Abstand H-T. Dieser Bereich zwischen eingestellter Tastweite T und Hintergrund ist ein kritischer Abstandsbereich 34. Dort sollte sich kein Objekt befinden, denn dann ist keine klare Zuordnung zum Tastbereich 30 oder Hintergrund 32 sichergestellt.

Ein wesentliches Element der Erfindung ist die Anzeigeeinheit 24. In einer ersten Ausführungsform der Erfindung (Fig. 1a bis 3b) ist die Anzeigeeinheit 24 kreisförmig ausgebildet und umfasst drei Anzeigebereiche 40, 42 und 44, die jeweils kreisbogenförmig ausgebildet sind und vorzugsweise aus LED-Elementen gebildet sind. Die Anzeigeeinheit kann auch in Form eines sogenannten "electronic paper" (farbig oder schwarz/weiß) ausgeführt sein.

Die Anzeigenbereiche entsprechen den Abstandsbereichen, wobei der erste Anzeigebereich 40 dem Tastbereich 30 entspricht, der zweite Anzeigebereich dem kritischen Abstandsbereich 34 und der dritte Anzeigebereich 44 dem Hintergrund. Im ersten Anzeigebereich 40 ist zunächst die eingestellte Tastweite T im Verhältnis zu einer maximal einstellbaren Tastweite des Lichttasters 10 anzeigbar. Dies ist in Fig. 1b erkennbar. Der karierte Bereich des ersten Anzeigebereichs 40 soll eine Beleuchtung, vorzugsweise durch aktivierte LED-Elemente, darstellen. Die Ausdehnung dieses leuchtenden Bereichs stellt die eingestellte Tastweite T im Verhältnis zur maximal einstellbaren Tastweite, die durch den gesamten ersten Anzeigebereich repräsentiert wird, dar. Bei Bezugsziffer 41 wäre also die Anzeigegrenze der maximal möglichen Tastweite. In dem Beispiel nach Fig. 1b beträgt die eingestellte Tastweite T etwa die Hälfte der maximal einstellbaren Tastweite.

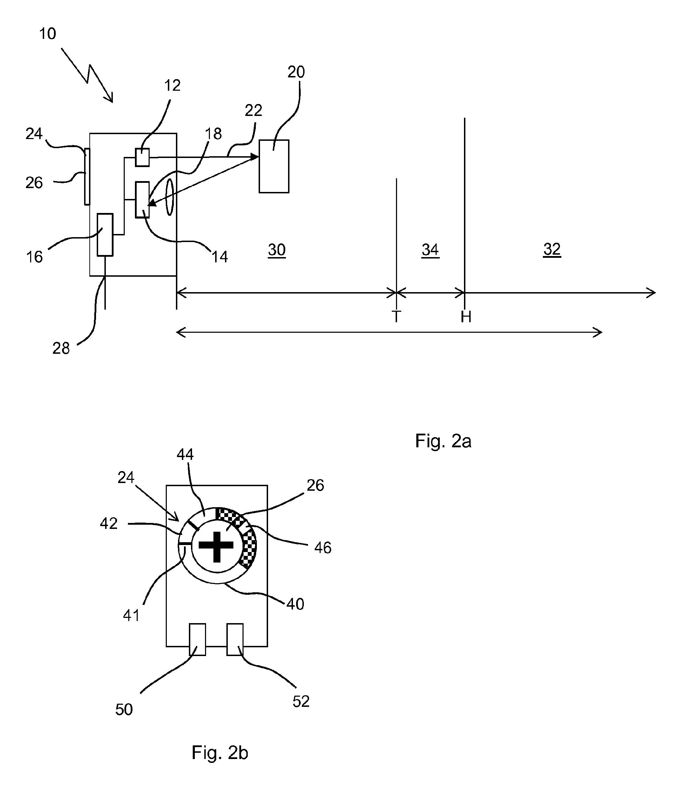

Befindet sich jetzt das Objekt 20 innerhalb der eingestellten Tastweite T, wie z.B. in Fig. 2a dargestellt, dann wird dies im ersten Anzeigebereich 40 durch Erlöschen einer der Entfernung des Objekts 20 zugeordneten LED dargestellt, wie in Fig. 2b an der Position 46 zu erkennen ist. Damit ist zumindest eine qualitative Anzeige der Entfernung möglich.

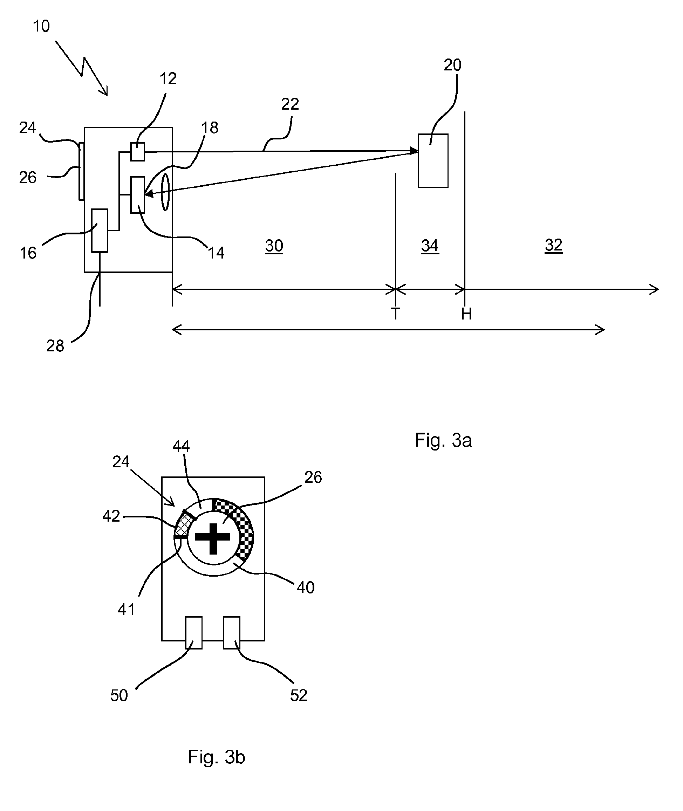

Befindet sich das Objekt 20 im kritischen Abstandsbereich 34, wie in Fig. 3a dargestellt, dann wird dies durch Leuchten des zweiten Anzeigebereichs 42 signalisiert, indem die dortige LED oder LEDs aktiviert werden, wie in Fig. 3b angedeutet.

Im dritten Anzeigebereich 44 wird schließlich angezeigt, wenn ein Objekt 20 sich im Hintergrund befindet, also in einem Abstand größer H.

In diesen Ausführungsbeispielen ist das Einstellelement 26 in der Mitte der kreisförmigen Anzeigeeinheit 24 positioniert und umfasst einen Drehpotentiometer, der z.B. mittels eines Kreuzschlitz-Schraubendrehers betätigt werden kann. Das Ein-stellelement 26 dient zum Einstellen der Tastweite T, nachdem zuvor ein Einstell-modus, beispielsweise mittels einer nicht dargestellten Starttaste oder einem Start-befehl, aktiviert wurde. Ein Ende des Einstellmodus wird durch die Auswerteeinheit 16 automatisch erkannt, wenn das Einstellelement 26 über eine vorbestimmte Zeit nicht betätigt wurde.

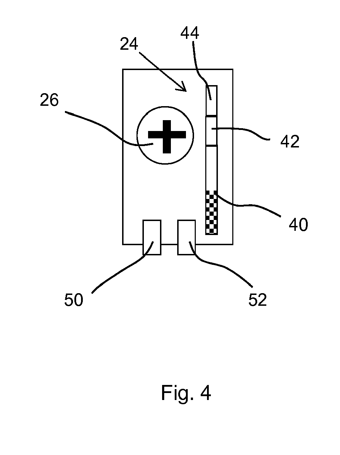

In einer alternativen, in Fig. 4 dargestellten Ausführungsform, könnte die Anzeigeeinheit 24 auch balkenförmig ausgebildet sein, so dass die einzelnen Anzeigebereiche 40, 42, 44 jeweils als Anzeigebalken ausgebildet sind. Die Funktionen der Anzeigebalken sind die gleichen wie beim ersten Ausführungsbeispiel.

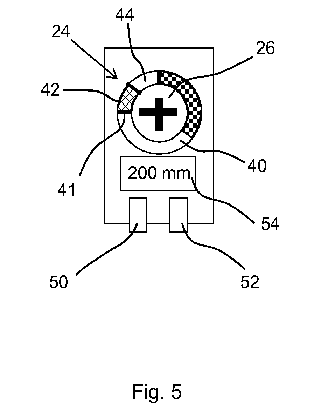

In einer alternativen, in Fig. 5 dargestellten Ausführungsform könnte die Anzeigeeinheit 24 auch in Form eines sogenannten "eletronic paper" ausgebildet sein, mit Anzeigebereichen 40, 42, 44 wie in den vorgenannten Ausführungsbeispielen.

In Weiterbildung der Erfindung kann die eingestellte Tastweite in einem zusätzlichen Display 54 angezeigt werden. Das Display kann als digitale Anzeige oder als "electronic paper" die Tastweite digital als Wert in mm oder in inch anzeigen.

In Weiterbildung der Erfindung können die Anzeigebereiche unterschiedliche Farben haben. So könnte beispielsweise der erste Anzeigebereich 40 durch grüne LEDs repräsentiert werden (Funktion ok, Tastweite eingestellt), der zweite Anzeigebereich 42 durch gelbe (Objekt im kritischen Abstandsbereich) und der dritte Anzeigebereich 44 durch blaue oder weiße (Objekt im Hintergrund).

Des Weiteren können zwei weitere Anzeige-LED 50 und 52 vorgesehen sein, wobei LED 50 den Status des Signalausgangs 28 angeben könnte und die LED 52 anzeigt, ob Betriebsspannung anliegt.

## Patentansprüche

1. Lichttaster mit Hintergrundausblendung mit
- einem Lichtsender (12),
- einem Lichtempfänger (14),
- einer Auswerteeinheit (16) zur Bestimmung des Abstandes zwischen dem Lichttaster (10) und einem Objekt (20) im Erfassungsbereich des Lichttasters (10),
- einem Einstellelement (26) zum Einstellen einer Tastweite (T), innerhalb derer ein Objekt (20) detektiert werden soll, wobei zwischen eingestellter Tastweite (T) und Hintergrund (32) ein kritischer Abstandsbereich (34) in Abhängigkeit von der eingestellten Tastweite (T) definiert ist,
- einem Signalausgang (28) zum Ausgeben eines Signals, wenn ein Objekt (20) innerhalb der eingestellten Tastweite (T) detektiert wird,
- einer Anzeigeeinheit (24) zur Anzeige, ob ein Objekt (20) sich innerhalb der Tastweite (T) befindet,
wobei die Anzeigeeinheit (24) wenigstens zwei Anzeigebereiche (40, 42) aufweist, wobei der erste Anzeigebereich (40) derart ausgebildet ist, dass die eingestellte Tastweite (T) im Verhältnis zu einer maximalen Tastweite (41) des Lichttasters (10) anzeigbar ist und der zweite Anzeigebereich (42) anzeigt, wenn ein Objekt (20) sich im kritischen Abstandsbereich (34) befindet, **dadurch gekennzeichnet, dass** die Entfernung eines erfassten Objekts (20) innerhalb der eingestellten Tastweite (T) in dem ersten Anzeigebereich (40) qualitativ anzeigbar (46) ist.

2. Lichttaster nach Anspruch 1, **dadurch gekennzeichnet, dass** ein dritter Anzeigebereich (44) vorgesehen ist, in dem anzeigbar ist, ob sich ein erfasstes Objekt (20) im Hintergrund (32) befindet.

3. Lichttaster nach einem der vorhergehenden Ansprüche, **dadurch gekennzeichnet, dass** der erste Anzeigebereich (40) aus mehreren LED's besteht, wobei ein aktivierter Teil der LEDs die eingestellte Tastweite angibt.

4. Lichttaster nach Anspruch 3, **dadurch gekennzeichnet, dass** die Entfernung des Objekts (20) innerhalb der eingestellten Tastweite (T) durch Erlöschen einer der aktivierten LEDs, die der Entfernung des Objekts zugeordnet ist, anzeigbar ist.

5. Lichttaster nach einem der vorhergehenden Ansprüche, **dadurch gekennzeichnet, dass** ein Einstellmodus zum Einstellen der Tastweite aktivierbar ist und ein Ende des Einstellmodus automatisch durch die Auswerteeinheit erkannt wird, wenn das Einstellelement über eine vorbestimmte Zeit nicht betätigt wurde.

6. Lichttaster nach einem der vorhergehenden Ansprüche, **dadurch gekennzeichnet, dass** die Anzeigeeinheit (24) ringförmig ausgebildet ist und die Anzeigebereiche (40, 42, 44) Abschnitte des Ringes bilden.

7. Lichttaster nach einem der vorhergehenden Ansprüche, **dadurch gekennzeichnet, dass** die Anzeigeeinheit (24) als Balkenanzeige ausgebildet ist.

8. Lichttaster nach einem der vorhergehenden Ansprüche, **dadurch gekennzeichnet, dass** die Anzeigeeinheit (24) ein Display (54) für die eingestellte Tastweite aufweist.

9. Lichttaster nach Anspruch 6, **dadurch gekennzeichnet, dass** das Einstellelement (26) als Drehpotentiometer ausgebildet ist, das sich im Inneren des Ringes befindet.

10. Lichttaster nach einem der vorhergehenden Ansprüche, **dadurch gekennzeichnet, dass** dieser als Triangulationslichttaster ausgebildet ist.

11. Lichttaster nach einem der vorhergehenden Ansprüche 1 bis 9, **dadurch gekennzeichnet, dass** der Lichtsender moduliertes Licht aussendet und die Auswerteeinheit die Entfernung über eine Bestimmung der Lichtlaufzeit bestimmt.

## Claims

1. A light sensing device having background suppression, comprising
- a light transmitter (12);
- a light receiver (14);
- an evaluation unit (16) for determining the spacing between the light sensing device (10) and an object (20) in a detection zone of the light sensing device (10);
- a setting element (26) for setting a sensing depth (T) within which an object (20) should be detected, wherein a critical spacing region (34) is defined between a set sensing depth (T) and a background (32) in dependence on the set sensing depth (T);
- a signal output (28) for outputting a signal when an object (20) is detected within the set sensing depth (T);
- a display unit (24) for displaying whether an object (20) is present within the sensing depth (T);
wherein the display unit (24) has at least two display regions (40, 42), wherein the first display region (40) is configured such that the set sensing depth (T) can be displayed in relation to a maximum sensing depth (41) of the light sensing device (10) and the second display region (42) indicates if an object (20) is present in the critical spacing region (34),
**characterized in that** the distance of an object (20) located within the set sensing depth (T) can be indicated qualitatively in the first display region (40).

2. The light sensing device in accordance with claim 1, further comprising a third display region (44) in which it can be indicated whether a detected object (20) is located in the background (32).

3. The light sensing device in accordance with any preceding claim, wherein the first display region (40) is composed of a plurality of LEDs, wherein an activated portion of the LEDs indicates the set sensing depth.

4. The light sensing device in accordance with claim 3, wherein a distance of an object (20) located within the set sensing depth (T) can be indicated by a going off of one of the activated LEDs which is associated with the distance of the object.

5. The light sensing device in accordance with any preceding claim, wherein a setting mode for setting the sensing depth can be activated and an end of the setting mode is automatically recognized by the evaluation unit when the setting element has not been actuated over a predefined period of time.

6. The light sensing device in accordance with any preceding claim, wherein the display unit (24) is of ring-like design and the display regions (40, 42, 44) form sections of the ring.

7. The light sensing device in accordance with any preceding claim, wherein the display unit (24) is configured as a bar graph.

8. The light sensing device in accordance with any preceding claim, wherein the display unit (24) has a display (54) for the set sensing depth.

9. The light sensing device in accordance with claim 6, wherein the setting element (26) is configured as a rotary potentiometer which is present in the interior of the ring.

10. The light sensing device in accordance with any preceding claim, wherein this is configured as a triangulation light sensing device.

11. The light sensing device in accordance with any preceding claim 1 to 9, wherein the light transmitter transmits modulated light and the evaluation unit determines the distance via a determination of the light propagation time.

## Revendications

1. Détecteur photoélectrique à occultation d'arrière-plan, comportant
- un émetteur de lumière (12),
- un récepteur de lumière (14),
- une unité d'évaluation (16) pour déterminer la distance entre le détecteur photoélectrique (10) et un objet (20) dans la zone de détection du détecteur photoélectrique (10),
- un élément de réglage (26) pour régler une largeur de détection (T) à l'intérieur de laquelle un objet (20) doit être détecté, une plage de distance critique (34) entre la largeur de détection réglée (T) et l'arrière-plan (32) est définie en fonction de la largeur de détection réglée (T),
- une sortie de signal (28) pour émettre un signal lorsqu'un objet (20) est détecté à l'intérieur de la largeur de détection réglée (T),
- une unité d'affichage (24) pour afficher si un objet (20) se trouve à l'intérieur de la largeur de détection (T),
l'unité d'affichage (24) comprenant au moins deux zones d'affichage (40, 42), la première zone d'affichage (40) étant réalisée de telle sorte que la largeur de détection réglée (T) par rapport à une largeur de détection maximale (41) du détecteur photoélectrique (10) est susceptible d'être affichée et que la seconde zone d'affichage (42) indique lorsqu'un objet (20) se trouve dans la plage de distance critique (34),
**caractérisé en ce que**
l'écartement d'un objet détecté (20) à l'intérieur de la largeur de détection réglée (T) est susceptible d'être affiché qualitativement dans la première zone d'affichage (40).

2. Détecteur photoélectrique selon la revendication 1, **caractérisé en ce qu'**il est prévu une troisième zone d'affichage (44) permettant d'afficher si un objet détecté (20) se trouve dans l'arrière-plan (32).

3. Détecteur photoélectrique selon l'une des revendications précédentes, **caractérisé en ce que** la première zone d'affichage (40) est constituée par plusieurs diodes électroluminescentes, une partie activée des diodes électroluminescentes indiquant la largeur de détection réglée.

4. Détecteur photoélectrique selon la revendication 3, **caractérisé en ce que** l'écartement de l'objet (20) à l'intérieur de la largeur de détection réglée (T) est susceptible d'être indiqué par extinction de l'une des diodes électroluminescentes activées qui est associée à l'écartement de l'objet.

5. Détecteur photoélectrique selon l'une des revendications précédentes, **caractérisé en ce qu'**un mode de réglage destiné à régler la largeur de détection est activable, et une fin du mode de réglage est reconnue automatiquement par l'unité d'évaluation lorsque l'élément de réglage n'a pas été actionné pendant une période prédéterminée.

6. Détecteur photoélectrique selon l'une des revendications précédentes, **caractérisé en ce que** l'unité d'affichage (24) est réalisée sous forme annulaire et les zones d'affichage (40, 42, 44) constituent des portions de l'anneau.

7. Détecteur photoélectrique selon l'une des revendications précédentes, **caractérisé en ce que** l'unité d'affichage (24) est réalisée sous forme d'affichage à barres.

8. Détecteur photoélectrique selon l'une des revendications précédentes, **caractérisé en ce que** l'unité d'affichage (24) est un écran d'affichage (54) pour la largeur de détection réglée.

9. Détecteur photoélectrique selon la revendication 6, **caractérisé en ce que** l'élément de réglage (26) est réalisé sous forme de potentiomètre rotatif qui se trouve à l'intérieur de l'anneau.

10. Détecteur photoélectrique selon l'une des revendications précédentes, **caractérisé en ce que** celui-ci est réalisé sous forme de détecteur photoélectrique à triangulation.

11. Détecteur photoélectrique selon l'une des revendications 1 à 9, **caractérisé en ce que** l'émetteur de lumière émet une lumière modulée et l'unité d'évaluation détermine l'écartement via une détermination du temps de parcours de la lumière.
